(19) Europäisches Patentamt

European Patent Office

Office européen des brevets

(11) EP 1 577 933 A2
(12) EUROPEAN PATENT APPLICATION

(43) Date of publication:
21.09.2005 Bulletin 2005/38

(51) Int Cl.⁷: **H01L 21/205**, C30B 29/40,
C30B 25/02, C30B 25/18

(21) Application number: 05251462.7

(22) Date of filing: 10.03.2005

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **17.03.2004 JP 2004075674
24.09.2004 JP 2004276337**

(71) Applicant: **Sumitomo Electric Industries, Ltd.
Osaka 541-0041 (JP)**

(72) Inventors:
• **Kasai, Hitoshi Itami Works of S.E. Ind. Ltd
Itami-shi Hyogo (JP)**
• **Motoki, Kensaki Itami Works of S.E. Ind. Ltd
Itami-shi Hyogo (JP)**

(74) Representative:
**Cross, Rupert Edward Blount et al
BOULT WADE TENNANT,
Verulam Gardens
70 Gray's Inn Road
London WC1X 8BT (GB)**

(54) **Method of manufacturing single-crystal GaN substrate, and single-crystal GaN substrate**

(57) Manufacture at lower cost of off-axis GaN single-crystal freestanding substrates having a crystal orientation that is displaced from (0001) instead of (0001) exact. With an off-axis (111) GaAs wafer as a starting substrate, GaN is vapor-deposited onto the starting substrate, which grows GaN crystal that is inclined at the same off-axis angle and in the same direction as is the starting substrate. Misoriented freestanding GaN substrates may be manufactured, utilizing a misoriented (111) GaAs baseplate as a starting substrate, by forming onto the starting substrate a mask having a plurality of apertures, depositing through the mask a GaN single-crystal layer, and then removing the starting substrate. The manufacture of GaN crystal having a misorientation of 0.1° to 25° is made possible.

EP 1 577 933 A2

**Description**

BACKGROUND OF THE INVENTION

Field of the Invention

The present invention relates to methods of manufacturing single-crystal gallium nitride (GaN) substrates used as the base of light-emitting and other optoelectronic devices made from Group III-V compound semiconductors, such as light-emitting diodes and semiconductor lasers.

Description of the Background Art

Beginning with blue LEDs, light-emitting devices in which nitride semiconductors are employed have already been made practicable. As the substrate in light-emitting devices employing nitride semiconductors, sapphire has almost without exception been used to date. Gallium nitride crystal films grow quite favorably onto sapphire substrates, and as a base material sapphire is tough and of ample mechanical strength. Defects are numerous in gallium nitride films grown onto sapphire substrates, yet in spite of this GaN semiconductor devices fabricated on sapphire emit light, and proliferation of defects leading to device deterioration is not an issue. Sapphire is a superior material for the growth of nitride semiconductor films.

Nevertheless, sapphire substrates also pose difficulties. Nitride-based semiconductor light-emitting elements employing sapphire substrates suffer from sapphire's lack of cleavability, from sapphire being an insulator, and from the serious mismatch between gallium-nitride crystal and sapphire, in that their lattices are incoordinate.

In manufacturing light-emitting diodes on sapphire, throughput has not been raised in the dicing stage because sapphire lacks cleavability, which has led to high costs. In producing semiconductor lasers on sapphire, creating high-grade resonator reflecting surfaces has not been possible, wherein there have been problems with the lasing characteristics and other quality-related difficulties.

Because sapphire is an insulator, providing electrodes on the top/bottom side of a sapphire device-substrate chip, as is the case with ordinary LEDs, is not possible. What has been done is an n-type GaN film for an n electrodes is layered onto the sapphire substrate, and a nitride layer such as a GaN film or InGaN film is epitaxially grown onto the GaN layer, after which the n-type GaN layer is exposed by etching into the margin as far as the n-type GaN layer, and n electrodes are formed onto the exposed area. This has meant increased processing steps and manufacturing time, which has led to high costs.

Moreover, inasmuch as two electrodes must be provided side-by-side on the same surface (along the frontside), a broad chip area is necessary, which has also driven up costs.

Since the lattice constants of sapphire and gallium nitride are considerably different, another problem has been that the lattice-constant mismatch between the substrate and the epilayer introduces numerous dislocations and other defects into the epilayer.

As it is, dislocations at a high density on the order of $1 \times 10^9$ cm$^{-2}$ are present within the gallium nitride epilayer of light-emitting devices in which sapphire substrates commercially available at present are employed. The dislocation density is on that order even in devices in which gallium nitride is grown onto a substrate of SiC, whose lattice mismatch with GaN is lower than sapphire's; thus, employing SiC substrates is not much of a remedy

As far as LEDs are concerned, the presence of such a high dislocation density does not prove to be a significant obstacle in practical terms. It is not as though the defects from dislocations increase or proliferate. As for semiconductor lasers, however, the current density is high, and therefore such defects are thought to be what stands in the way of prolonging semiconductor laser lifespan. This means that in semiconductor laser implementations, substrates with a smaller mismatch are being sought. But as LEDs are made to have higher output power, demands for lower-dislocation epilayers also on substrates for LEDs will presumably follow.

It stands to reason that the ideal substrates on which nitride-based semiconductor films should be grown are substrates of gallium nitride crystal. If gallium nitride crystal substrates of high-quality can be produced, the problem of lattice mismatch between substrate and film can be resolved. Gallium nitride crystal possesses distinct cleavability, and thus it is possible to use the natural cleavage planes as the reflecting mirrors of a laser resonator. What is more, gallium nitride is not an insulator like sapphire, but a semiconductor, and therefore electrodes can be layered onto the substrate bottom surface, which means that GaN chips as device substrates can be of reduced surface area. Accordingly, gallium-nitride crystal substrates are considered to be optimal as base substrates for nitride-based semiconductor film growth.

Nevertheless, in spite of GaN's optimal properties, as a base substrate for growing nitride films at present sapphire is still being used almost exclusively. One reason for this is that gallium-nitride crystal freestanding substrates of high quality and practicable size have not proven to be readily manufacturable.

Although at ultra-high pressure, high temperature GaN can be made into a melt, and GaN crystal can be pulled from the melt, with miniscule crystal grains being all that can be produced, at present it has not been possible to produce pieces that are large in diametric span.

Given the difficulties involved in getting GaN into the molten state, the practice is to produce gallium nitride crystal by a vapor-phase method in which source gases are reacted in the vapor phase. The method, employed to grow native films, in which a gallium nitride film is grown onto a heterocrystal substrate by vapor-phase synthesis, is employed as an alternative to substrate-growing methods.

Known methods for the vapor-phase growth of GaN films include HVPE, sublimation, MOC and MOCVD.

1. HVPE (hydride vapor-phase epitaxy) is a method in which a vessel, or "boat," into which metallic Ga is introduced is provided in the upper end of a hot-wall reaction furnace (reactor), and a susceptor is furnished in the lower end. A base substrate is set onto the susceptor, the entire reactor is heated, and HCl gas diluted with hydrogen is streamed onto the Ga boat through the upper end to synthesize GaCl gas is by the reaction $2Ga + 2HCl \rightarrow 2GaCl + H_2$. Hydrogen-diluted $NH_3$ gas is then streamed in nearby the susceptor, to where the GaCl gas has descended, to initiate the reaction $2GaCl + 2NH_3 \rightarrow 2GaN + 3H_2$ and laminate a GaN crystal layer onto the base substrate.

2. Sublimation is a method in which a base substrate is anchored upstream in a reactor and GaN polycrystal is placed downstream in the reactor. A temperature gradient is set up in the reactor, with the lower end being at a higher temperature and the upper end being at a lower temperature, whereby the polycrystal gasifies, ascends, and little by little deposits onto the base substrate, producing a single-crystal film.

3. MOCVD (metalorganic chemical vapor deposition) is a method in which a base substrate is set onto a susceptor provided in the lower end of a cold-wall reactor, the susceptor is heated up, and with gaseous hydrogen as a carrier gas, trimethyl gallium (TMG), triethyl gallium (TEG), and $NH_3$ gas are streamed in through the upper end of the reactor to initiate the vapor-phase reaction $(CH_3)3Ga + NH_3 \rightarrow GaN + 3CH_4$ and deposit GaN crystal onto the base substrate. At present, this is the method most commonly employed as a way of growing a nitride-based semiconductor film onto a sapphire substrate. An organic metal is made the source material, hence the name. Nevertheless, the present applicants do not consider it to be a very satisfactory method, in that because a carbon-containing substance is reacted directly with $NH_3$, carbon gets mixed into the GaN, and on account of the carbon, a yellowish discoloration is imparted to the crystal, and a deep donor level results.

4. MOC (metalorganic chloride) is a technique in which an organic metal is employed as the Ga source material, but the metal is not reacted directly with $NH_3$, and is instead reacted for the time being with HCl to synthesize GaCl as an intermediate product, which is then reacted with $NH_3$ to render GaN. MOC is a technique unique to the present applicants, who have not seen any similar examples. A superior advantage gained through MOC is that since GaCl is produced as an intermediate product, carbon is unlikely to get mixed into GaN as the final product.

Sapphire ($Al_2O_3$) is for the most part what is used as the base substrate. Although the difference in lattice constant between sapphire and GaN is considerably great, leading to large dislocation density in the deposition film, even at that GaN on sapphire can be made into LEDs—into LEDs of long lifespan. There are, however, reports of employing the likes of GaAs and SiC as base substrates. The growing of GaN with GaAs as a base substrate was earnestly attempted in the 1960s, but ended in failure with GaN not growing well. Today what is done is to grow the GaN epitaxially onto a base substrate on which a thin (20 to 80 nm) buffer layer grown at low temperature has been built.

The foregoing techniques are GaN thin-film growth methods. Thick films cannot be produced by these methods per se. Inasmuch as thin films are by definition thin, even if there is a misfit between film and substrate the film will not peel loose or be otherwise compromised, but when proceeding to deposit GaN thickly, internal stress grows to be considerable, such that the GaN peels loose or buckles and cannot be grown thick. Given the circumstances, ELO (epitaxial lateral overgrowth) is utilized to reduce the dislocation density by attenuating the internal stress.

An SiN or $SiO_2$ film is formed onto a base substrate, onto which a mask perforated—if one assumes that right-triangular tiles some 2 to 4 μm to a side have been spread unilaterally over the film—with apertures of 1 to 2 μm diameter in locations that correspond to the right-triangular vertices is created. GaN is vapor-deposited through the mask. At first GaN crystal grows from the base substrate in the apertures; then it creeps over onto the mask, growing sideways. The GaN crystal then collides with crystal that has grown through adjoining apertures, and thereafter uniform, flat-plane overgrowth (c-plane growth) ensues. On the mask the dislocations extend horizontally and from side to side they run into each other, resulting in a reduction in dislocations in the crystal on the mask. The high dislocation density over the apertures is unaffected, but above the mask (the covered areas), the dislocation density becomes lower. The literature on ELO is extensive; International Publication Number PCT/WO99/23693 is an instance in which ELO onto GaAs base substrates is discussed.

Freestanding GaN crystal can be obtained by ELO of GaN crystal thickly onto a GaAs substrate, followed by removal of the substrate. A plurality of freestanding GaN-crystal substrates can be obtained by producing thicker GaN crystal through ELO onto a GaAs substrate, eliminating the substrate to yield a GaN ingot, and then slicing the ingot into thin wafers. This technique is presented in International Publication Number PCT/WO99/23693.

What has been described up to this point is conventional technology for the growth of GaN crystal. Now the discussion will take a completely different tack, and describe crystal substrates that are "miscut," or "off-axis." There have been demands for miscut substrates both in implementations on Si and in implementations on GaAs. Speaking of GaAs, substrates with an exact, on-axis (100) face are the usual, but if a film is grown onto an exact substrate, the face of the film will not necessarily turn out to be smooth and planar, and will in some instances buckle. One way to address this is to incline the substrate orientation slightly from (100) exact, and on that grow films to create devices. In this way inclining the crystal face off slightly from the low index is referred to as "misorienting," and such substrates are called "misoriented," "miscut," or "vicinal" substrates. The angle of inclination of the crystal face is referred to as the "misorientation" or "off-axis" angle.

This is not to say that misorientation is always the case, but depending on the objectives, misoriented substrates will be appropriate. Since too much of an inclination displaces the cleavage planes, substrates whose orientation is inclined at a slight angle are created. Misorienting is often the practice with existent semiconductor substrate crystal such as Si, GaAs, and InP. While there are various opinions as to the optimal range of misorientation angles, none has come to be the established view. The ranges cited in Japanese Unexamined Pat. App. Pub. Nos. H02-239188, S64-32686, S64-22072, S64-15914, and H01-270599, and in Japanese Pat. No. 3,129,112 relate to misoriented substrates of GaAs and InP among other crystal. Apart from these publications, extensive literature on misorientation angles concerning Si, GaAs, and InP exists.

For GaAs and InP substrates, since long, large-scale (100) crystal ingots can be obtained using the horizontal Bridgeman (HB) or liquid encapsulated Czochralski (LEC) methods, what is done is to cut the ingot diagonally along an orientation oblique to its axis, with a slicer such as an inner-diameter saw, a circular saw, or a wire saw, to yield misoriented wafers. Since they are long, even though the ingots are cut along a diagonal orientation, wasted material is not really an issue.

For substrates of GaN, showings in terms of large-scale, high-quality products having been made commercially available have been meager so far; thus there are no calls for substrates of misoriented GaN. Misoriented GaN substrates do not exist, nor does literature on having grown GaN onto such substrates. Therefore, whether the surface morphology in instances in which films are grown onto misoriented GaN rather than onto exact GaN substrates is better or not is also not clear. Still, there is literature on GaN thin films grown onto misoriented sapphire substrates.

Japanese Unexamined Pat. App. Pub. No. H07-201745 states that while growing *p*-type GaN thin films is difficult, growing GaN by MOCVD onto a sapphire substrate ($\alpha$-Al$_2$O$_3$) having misorientation from the (0001) plane enables thin films of *p*-type GaN crystal to be produced. Ultimately, GaN thin film only lays atop the sapphire. With *p*-type thin films being the goal, thick crystal is not an objective, and nothing is mentioned as to whether the GaN films are misoriented or not.

Japanese Unexamined Pat. App. Pub. No. H11-74562 states that growing a GaN thin film by MOCVD onto a misoriented sapphire substrate ($\alpha$-Al$_2$O$_3$) having a stepped geometry results in the active layer being quantum dots or quantum wires, effectively trapping carriers and light, which therefore builds up the output power and prolongs the lifespan. Inasmuch as the GaN is thin, the aim here is not to produce substrates. And whether the GaN is misoriented or not is not mentioned.

Takayuki Yuasa, et al., in "Effect of Slight Misorientation of Sapphire Substrate on Metalorganic Chemical Vapor Deposition Growth of GaN," *Japanese Journal of Applied Physics: Part 2*, Vol. 38, No. 7A, July 1, 1999, pp. L703-L705, state that in GaN grown thinly (4 $\mu$m) onto a (0001) sapphire substrate ($\alpha$-Al$_2$O$_3$) having a misorientation of 0.03° to 0.25°, the surface morphology is improved (the roughness is reduced) and the electroluminescence is enhanced. This is not about producing thick films of GaN, in that the GaN thin film is left as it is layered onto the sapphire substrate. And nothing is mentioned as to the crystal orientation of the GaN thin film.

M.H. Xie, et al., in "Reduction of threading defects in GaN grown on vicinal SiC (0001) by molecular-beam epitaxy," *APPLIED PHYSICS LETTERS,* Vol. 77, No. 8, August 21, 2000, pp. 1105-1107, state that growing a GaN thin film by MOCVD onto a (0001) 4H-SiC substrate misoriented by 3.5° improved the surface morphology and increased the photoluminescence over one grown onto a (0001) exact SiC substrate. Being thin, the GaN does not turn out as substrate crystal, however, and is left as it is layered onto the SiC substrate. And the crystal orientation of the GaN is not mentioned.

SUMMARY OF THE INVENTION

Although it is not the case that misoriented GaN substrates are being called for, expectations are that misoriented substrates will come to be sought after, in the same way that GaAs as well as InP substrates have come to be. GaN films grown onto misoriented GaN substrates are likely to be of higher quality than GaN films grown onto exact GaN substrates. Although it is true that that is not yet understood, misoriented GaN substrates do hold some promise and should come into demand.

In that case, if, like with GaAs and InP, single-crystal growth from the liquid phase (by the HB method or the LEC method) were possible and long, large-diameter, single-crystal GaN ingots could be made, then it would suffice to set the ingots at an inclined angle and slice them, and thus produce miscut wafers simply. Nevertheless, in the case of GaN crystal, long, single-crystal ingots cannot be grown from the liquid phase. What would seem to be a likely approach would be to grow GaN onto a single-crystal starting substrate of a material that differs from GaN, obtain GaN crystal having a good measure of thickness, remove the starting substrate to render a GaN boule, and then slice the boule diagonally to render miscut GaN wafers.

The portion lost to waste, however, would be so large as to rule out this approach. Suppose, for example, that one desires to produce a 2-inch (51 mm) diameter, 500-$\mu$m thickness GaN wafer having an off-axis angle of 5°. Since 51(sin 5°) = 4.4, producing a GaN boule having a height of 4.9 mm and slicing it at an inclination angle of 5° would, factoring in the kerf loss, yield a single miscut wafer. Since nine 500-$\mu$m thick sheets can be gotten out of a boule 4.9 mm in height if they are cut as exact (on-axis) substrates, eight substrates' worth ends up going to waste. A drawback of this sort is as pronounced as the misorientation angle is large. Because at present GaN produced by vapor-phase techniques is thin, such a drawback is quite serious.

If thicker GaN single-crystal boules with a height of 30 mm could be made, and wafers misoriented on the order of 1° to 3° could be obtained, the loss would be less; but at the present stage, production of GaN crystal that thick is not possible. That present stage is a level at which material of some 1 mm thickness can finally be produced, and at best is a level at which, taking a great deal of time, at long last 10-mm thick crystal may be created.

GaN single-crystal at the present stage is only producible as thin crystal, albeit of large surface area. Consequently, if (0001) exact GaN is sliced diagonally the loss would be large. In addition to that there is one more problem. GaN is grown slowly by vapor-phase deposition, and along with growth the dislocation density comes to change. GaN crystal is such that at the start of growth the dislocation density is high, but as the growth proceeds, the dislocation density declines; thus if the crystal is cut aslant the dislocation density in-plane would prove to be conspicuously non-uniform.

In the present invention, an off-axis (111) GaAs crystal substrate is utilized, and GaN is vapor-deposited thickly onto the GaAs substrate and the substrate is removed. Doing so enables an off-axis GaN crystal substrate to be obtained. The present invention, utilizing an off-axis (111) GaAs crystal substrate, vapor-depositing GaN thickly onto the GaAs substrate to a film-thickness extent equivalent to that of a plurality of sheets, removing the GaAs substrate to yield a GaN boule, and slicing the boule in the off-axis planes, which are orthogonal to the growth axis, also enables batch manufacturing of plural sheets of miscut GaN substrate crystal.

In another aspect of the invention, an ELO technique is utilized, in which a mask having numerous apertures arrayed periodically (at a 1 $\mu$m to 4 $\mu$m pitch) is layered onto an off-axis (111) GaAs substrate, and GaN is vapor-phase deposited onto the substrate.

Alternatively, a technique that also can be adopted in the present invention is facet growth, in which a mask in a striped or dotted pattern having a greater pitch (30 $\mu$m to 400 $\mu$m) is layered onto the substrate, and while facets of GaN are created and sustained the crystal is grown.

From the following detailed description in conjunction with the accompanying drawings, the foregoing and other objects, features, aspects and advantages of the present invention will become readily apparent to those skilled in the art.

BRIEF DESCRIPTION OF THE DRAWINGS

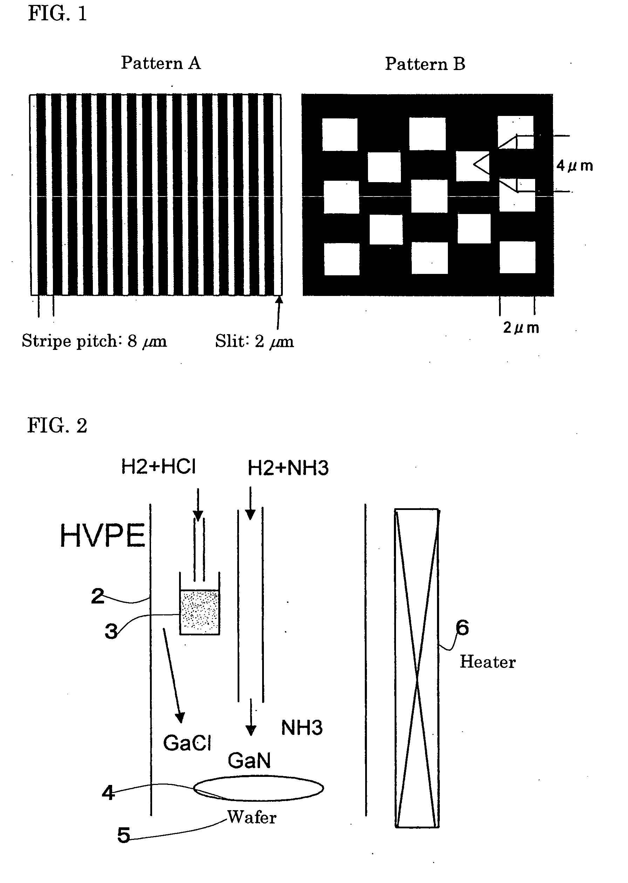

Fig. 1 is diagrams of mask patterns that in the present invention are formed as ELO masks onto a GaAs substrate. Pattern A is a stripe array in which slits 2 $\mu$m wide and shielding stripes 6 $\mu$m wide extend in parallel at a pitch of 8 $\mu$m. Pattern B is a configuration perforated by apertures 2 $\mu$m to a side as squares on the vertices of repeating right triangles that are right-triangular figures, 4 $\mu$m to a side, spread over the pattern.

Fig. 2 is a diagram illustrative of an HVPE technique in which, with a Ga boat provided in the upper portion of a hot-wall reactor, and in the lower part, a susceptor on which a starting substrate (wafer) is set, the Ga boat and the starting substrate are heated with an ambient heater, hydrogen-diluted HCl is streamed in from the upper end and reacted with the Ga to form GaCl, and the GaCl is reacted with $NH_3$ to grow GaN atop the starting substrate.

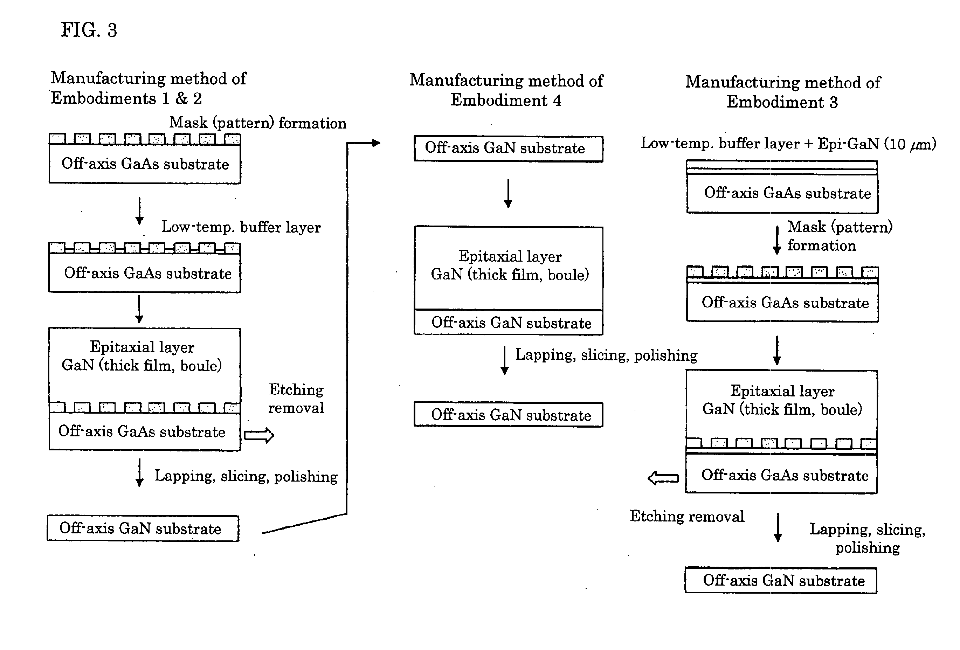

Fig. 3 is a diagram explanatory of a manufacturing procedure of Embodiments 1 and 2, in which the procedure has been rendered so that by forming a mask onto an off-axis GaAs starting substrate, vapor-depositing GaN through the mask, and removing the off-axis GaAs starting substrate and the mask, misoriented GaN crystal is obtained; the figure is also a diagram explanatory of an Embodiment 4 manufacturing procedure for epitaxially growing GaN onto the thus created misoriented GaN crystal as a base substrate to produce thick misoriented GaN crystal, and slicing the crystal thin to produce a plurality of miscut GaN substrates; and the figure is also a diagram explanatory of an Embodiment 3 manufacturing procedure rendered so as, onto an off-axis GaAs starting substrate, to layer a low-temperature-growth GaN buffer layer, further layer a mask, and epitaxially grow GaN thick, and so as to remove the off-axis GaAs starting substrate and the mask to yield a misoriented GaN crystal substrate.

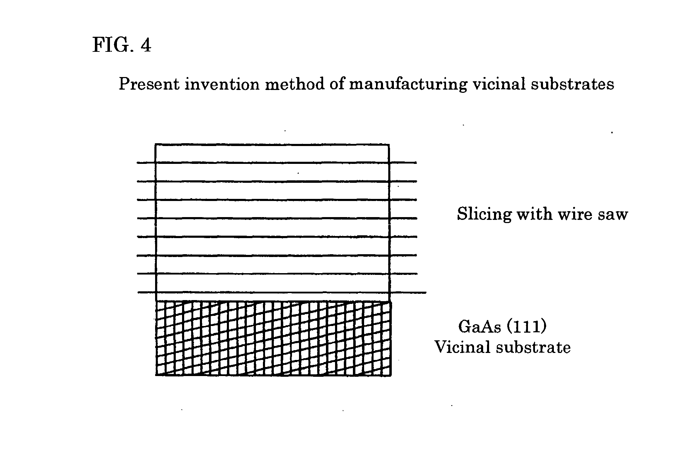

Fig. 4 is a diagram for explaining advantages of the present invention, in which it is arranged that after growing misoriented GaN crystal by vapor-phase deposition onto an off-axis (111) GaAs starting substrate, the GaAs starting substrate is removed and the GaN crystal is cut at right angles to the growth axis to yield miscut GaN crystal wafers without waste.

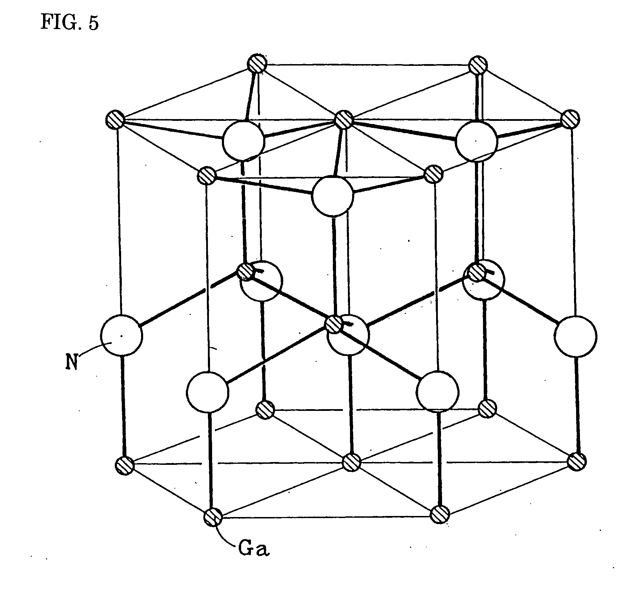

Fig. 5 is an atomic model diagram representing the crystalline structure of GaN.

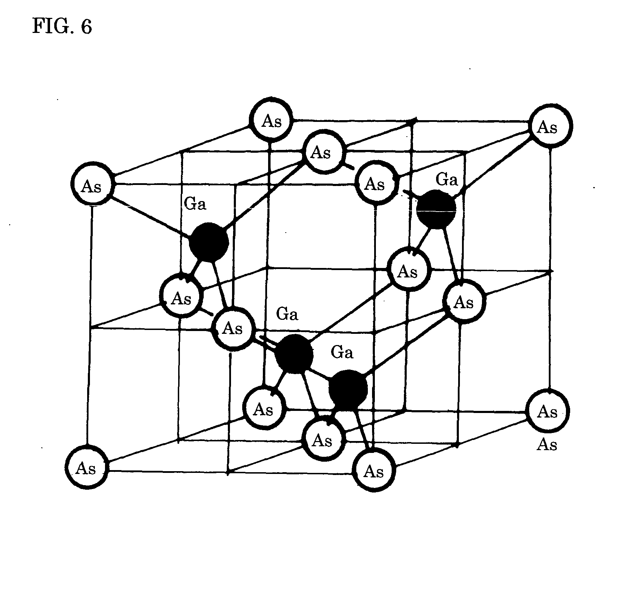

Fig. 6 is an atomic model diagram representing the crystalline structure of GaAs.

## DETAILED DESCRIPTION OF THE INVENTION

The present invention will now be discussed more specifically.

HVPE, MOC, MOCVD, and sublimation are, as has already been mentioned, available ways of growing gallium-nitride crystal, and the present invention can be implemented by any of the methods. Here the discussion will focus on instances in which HPVE (sketched out in Fig. 2) is utilized. The HVPE utilized herein is a technique as follows.

A quartz boat into which metallic Ga has been introduced is provided in the upper part of a hot-wall reactor, and a starting substrate is retained and heated by means of a susceptor in the reactor lower end; HCl diluted with hydrogen is flowed through the reactor upper end and the temperature is raised to 800°C or more to initiate the reaction $Ga + HCl \rightarrow GaCl$ and flow GaCl gas toward the lower end, and in the lower end, by the GaCl and by $NH_3$ gas carried by hydrogen gas, the reaction $GaCl + NH_3 \rightarrow GaN$ is initiated to create GaN and deposit the GaN onto the heated substrate. Advantages to the HVPE technique are that the growth rate is rapid, carbon contamination is slight, and the equipment, being comparatively simple, is sound. It is an optimal technique for producing bulk GaN crystal.

Nevertheless, vapor-phase growth methods such as MOCVD, MOC, and sublimation can also be employed in the present invention.

Fundaments of the present invention are that a GaAs baseplate having an off-axis orientation angle is utilized as a starting substrate, single-crystal GaN is vapor-deposited onto the GaAs starting substrate, and the GaAs starting substrate is removed to create a freestanding GaN crystal substrate lent an off-axis orientation angle.

The present inventors found that vapor-depositing GaN with off-axis GaAs single crystal as a starting substrate made off-axis GaN single crystal. Exploiting the principle of this completely new awareness, the present invention creates an off-axis GaN substrate by having an off-axis GaAs baseplate be the starting substrate, and vapor-depositing GaN onto the starting substrate. A crucial point, moreover, is that the GaN off-axis direction and inclination angle may be designated entirely by the orientation and angle of inclination of the GaAs baseplate as the starting substrate. The present invention thus makes it possible to manufacture GaN single-crystal substrates with an orientation of choice, and with an inclination angle of choice.

Off-axis GaN crystal can of course be manufactured by growing the crystal directly onto an off-axis GaAs (111) substrate. A variety of techniques other than that can be used to manufacture off-axis GaN through off-axis GaAs substrates.

A device that can be employed is to layer, onto a (111) GaAs substrate having an off-axis orientation, a mask ($SiO_2$ or SiN) having numerous periodically distributed tiny apertures, and vapor-deposit GaN through the mask, to make it so that the dislocations grow sideways and so that the dislocation density in the portions of the crystal above the mask becomes lower. What this means is that the ELO method described previously can be applied to vicinal substrates. By ELO employing a mask, off-axis GaN also grows onto—and its misorientation or off-axis orientation is determined by—a misoriented (111) GaAs substrate.

In carrying out ELO, a GaN buffer layer (20 nm to 80 nm) may be grown thinly, and then the mask layered, onto the off-axis (111) GaAs substrate. Off-axis GaN crystal can be grown in that case as well. After the GaN crystal has grown to an appropriate thickness, the substrate and mask are removed, whereupon freestanding GaN crystal having an off-axis orientation is made. And since in this case ELO is utilized, material of fewer dislocations is obtained.

A still further option is to use facet growth, in which $SiO_2$ or SiN patterned in a larger (striped or dotted) configuration is layered onto a starting substrate, crystal is grown while facets of the crystal are sustained, and in the regions where the crystal grows from the masked portions, dislocations are swept together, defining dislocation-collecting sites, which makes the dislocation in the remaining areas, which are over the mask openings, low.

The present invention yields GaN wafers possessing a desired off-axis orientation by growing GaN single crystal onto an off-axis (111) GaAs starting substrate as illustrated in Fig. 4, and cutting the monocrystal at right angles to the growth axis. Because the wafers may be sliced not diagonally, but at right angles, with respect to the axis, wastage is slight. Since it is often the case that thin crystal is all that is possible, this result is significant.

Suppose, for example, that in order to get wafers 400 μm thick out of (0001) exact GaN, a crystal 2 inches in diameter and 1000 μm in thickness is produced. If the wafers are on-axis, two can be gotten even including the kerf loss, but only a single 1° off-axis wafer 400 μm in thickness can be procured; and if the wafer were to be 2° off-axis, 400-μm thick GaN, then even one could not be obtained.

In contrast, with the present invention, in a instance in which 2° off-axis wafers are desired, because 2° off-axis GaN is grown onto a 2° off-axis GaAs starting substrate, two 2° off-axis wafers of 400 μm thickness can be obtained from a crystal 1000 μm in thickness. Inasmuch as GaN wafer is extremely costly, this result is significant.

Furthermore, in GaN crystal, because the dislocation density and other properties at the start of growth, midway through, and at the close will differ, if the crystal is cut diagonally, the dislocation density can vary greatly depending on the region of the wafer; but since in the present invention the cuts are made at right angles to the growth axis, within the wafer plane the growth age is at identity, which thus minimizes fluctuations in dislocation density and keeps the quality consistent.

Although the present invention has such effects, its value lies more in the discovery of predictability, in that the vicinal angle and off-axis direction of the GaN crystal can be designated in advance by the vicinal angle and direction of the starting substrate.

Because the GaAs baseplate that the present invention utilizes as the starting substrate turns out to be mass producible, and because it has already demonstrated proven performance for nearly twenty years and is readily, inexpensively available, the present invention is in condition to be readily embodied. Although what is sold commercially is largely (100) exact GaAs substrates, since long (100) GaAs single-crystal ingots are manufacturable by the LEC or HB methods or by the vertical boat method, manufacturing miscut wafers by cutting such an ingot diagonally is possible.

The gist of the present invention lies in the vicinal angle $\alpha$ of the (111) off-axis GaAs substrate and the vicinal angle $\beta$ of the GaN grown onto the substrate being equal ($\beta = \alpha$), and in uniquely determining, according to the orientation of the GaAs inclination, the inclination-angle direction of the GaN. Although it will be clear in the embodiments, the inclination-angle direction may be expressed by how the (111) GaAs substrate normal (which forms the angle $\alpha$ with the [111] direction, wherein $\alpha$ is the vicinal angle) is inclined with respect to the two directions [11$\bar{2}$] and [1$\bar{1}$0] that are orthogonal to [111].

The (0001) face of GaN crystal grows so as to overlie the (111) face of GaAs. The inclination-angle direction can be expressed by how the direction normal to the GaN (which forms the angle $\beta$ with [0001]) is inclined with respect to [1$\bar{1}$00] and [11$\bar{2}$0], which are orthogonal to [0001]. Then, the present inventors found that when the GaAs substrate normal is off-axis toward the [11$\bar{2}$] direction, the normal to the GaN crystal is off-axis toward [1$\bar{1}$00], and that when the GaAs substrate normal is off-axis toward the [1$\bar{1}$0] direction, the normal to the GaN crystal is off-axis toward the [11$\bar{2}$0] direction. This means that the [1$\bar{1}$00] direction in GaN coincides with the [11$\bar{2}$] direction in GaAs, and that the [11$\bar{2}$0] direction in GaN coincides with the 1$\bar{1}$0] direction in GaAs. Thus the GaAs [111] axis coincides with [0001] in GaN.

The reasons why such correlations hold were speculated upon.

Fig. 5 is an axonometric perspective diagram representing the crystalline structure of GaN. The diagram actually includes a number of cells; the plurality of cells required to represent the crystalline structure as a hexagonal system is illustrated, since the symmetry of such a system is readily understood. The large white spheres are nitrogen atoms, and the small spheres are Ga atoms. In the center of the bottom plane is Ga; centered there is a regular hexahedron at each vertex of which a Ga atom is present. The directions of the lines that from the center Ga in the bottom plane join to the six Ga atoms along the hexagonal perimeter are, going counterclockwise: [2$\bar{1}\bar{1}$0], [11$\bar{2}$0], [$\bar{1}$2$\bar{1}$0], [$\bar{2}$110], [$\bar{1}\bar{1}$20] and [1$\bar{2}$10]. These are the directions of the Ga-Ga bonds in GaN. The directions in which gallium atoms are not present are [1$\bar{1}$00], etc.

Fig. 6 is an axonometric perspective diagram illustrating the crystalline structure of GaAs. The structure has a hexagonal system, and is sphaleritic (of the zincblende type). The black spheres are Ga, and the white spheres are As. The Ga atoms are bonded with their four nearest-neighbor As atoms surrounding them above and below to the left and the right. The directions of the four bonds are: [111], [1$\bar{1}\bar{1}$], [$\bar{1}$1$\bar{1}$] and [$\bar{1}\bar{1}$1]. The diagonal plane that in this diagram contains three Ga atoms is (111). Each Ga atom ties in to the six Ga atoms in its second nearest neighbor sites; the directions of those ties (they are not bonds) are: [$\bar{1}$10], [01$\bar{1}$], [10$\bar{1}$], [1$\bar{1}$0], [0$\bar{1}$1] and [$\bar{1}$01]. These are the directions of the Ga-Ga bonds in the surface of (111) GaAs.

The directions along which the six Ga atoms at the vertices of the regular hexahedron containing the Ga atoms in the (111) plane of GaAs join with the center Ga atom are the just-noted [$\bar{1}$10], [01$\bar{1}$], [10$\bar{1}$], [1$\bar{1}$0], [0$\bar{1}$1] and [$\bar{1}$01], while the directions along which the six Ga atoms at the vertices of the regular hexahedron containing the Ga atoms in the (0001) plane of GaN join with the center Ga atom are the above-noted [2$\bar{1}\bar{1}$0], [11$\bar{2}$0], [$\bar{1}$2$\bar{1}$0], [$\bar{2}$110], [$\bar{1}\bar{1}$20] and [1$\bar{2}$10]. Thus, in GaAs and GaN, a Ga commonality obtains.

In (111) off-axis GaAs as well, since the Ga atoms in the surface are aligned almost regularly, the Ga-Ga directions in GaAs and the Ga-Ga directions in GaN should be in common. What this means is that along the GaAs/GaN boundary, [$\bar{1}$10], [01$\bar{1}$], [10$\bar{1}$], [1$\bar{1}$0], [0$\bar{1}$1] and [$\bar{1}$01] in GaAs are equivalent to [2$\bar{1}\bar{1}$0], [11$\bar{2}$0], [$\bar{1}$2$\bar{1}$0], [$\bar{2}$110], [$\bar{1}\bar{1}$20] and [1$\bar{2}$10] in GaN. Such being the case, the supposition would be that the misorientation of the GaAs normal with respect to [$\bar{1}$10], and the misorientation of GaN with respect to [2$\bar{1}\bar{1}$0] correspond perfectly.

Embodiment 1

*Method of manufacturing off-axis GaN substrates by growing GaN crystal onto a misoriented GaAs substrate on which an ELO mask is layered or is not layered*

By a procedure as follows, GaN crystal was produced atop an off-axis GaAs starting substrate, made into a freestanding film, lapped and polished, and examined as to its misorientation and its crystalline properties.

The (111) A face of off-axis GaAs was utilized as the starting substrate. GaAs is a cubic-system crystal of the zincblende (ZnS) type. The GaAs (111) planes are faces in which there is threefold rotational symmetry. The GaAs (111) planes comprise a face in which only Ga appears in the surface, and a face in which only As atoms appear in the surface. The former is called the (111) Ga face or the (111) A face; the latter is called the (111) As face or the (111) *B* face. In the present embodiment, GaAs (111) crystal was used with the Ga face facing up.

Since a (111) Ga face has threefold symmetry, hexagonal-system crystal can be grown onto that face. However, it was not strictly a (111) Ga face, but had been misoriented. The crystal directions *<hkm>* that may exist on a (111) face satisfy $h + k + m = 0$. Among these the directions that are low-index crystal directions and are orthogonal to each other are $<11\bar{2}>$ and $<1\bar{1}0>$. (Herein, "<...>" represents a family of directions, while "[...]" represents an individual direction. On the other hand, "(...)" represents an individual plane, while "{...}" represents a family of planes. A "family" representation is the group of all of the planes or directions that are interchanged by a symmetry operation that the crystal possesses.) A GaAs plane designated *"(hkm)"* means that its unit face is *al h, bl k* and *cl m*—the lengths of the intercepts on the *a*-axis, *b*-axis and *c*-axis. The indices *h, k, m* are the reciprocals of the intercepts and are integers. The direction *[hkm]* signifies the direction normal to the *(hkm)* plane.

With hexagonal crystalline systems, c-axis directions are a bit different: As far as the preceding three indices are concerned, given that the lengths of intercepts where a plane cuts axes *(a, b, d)* that are 120° apart, defined in the c-plane, are *al h, bl k* and *dl m,* then those three indices would be *hkm.* The rule $h + k + m = 0$ holds true at all times. For a fourth index *n,* it will be that the intercept in which the plane cuts the *c*-axis is *dn.* Thus, hexagonal-system planes may be designated by the four indices *(hkmm,* with the direction [hkmn] being defined as the normal to the plane *(hkmn).* This is the same as is the case with cubic crystalline systems.

The following fourteen misorientations (off-axis angles) for the starting substrate were adopted:

*Group I-* seven misorientations in which, in terms of the vector normal to the substrate topside, the crystal orientation [111] was inclined 0.1°, 0.3°, 1°, 5°, 10°, 20° and 25° towards a $<1\bar{1}0>$ direction.
*Group II-* seven misorientations in which, in terms of the vector normal to the substrate topside, the crystal orientation [111] was inclined 0.1°, 0.3°, 1°, 5°, 10°, 20° and 25° towards a $<11\bar{2}>$ direction.

All the starting substrates were miscut GaAs baseplates.

Onto some of these miscut GaAs substrates, GaN was grown by epitaxial lateral overgrowth (ELO) in which Pattern A and Pattern B masks as below were layered onto the substrates, while with the other substrates, ELO was not employed to grow the GaN.

*Pattern A-* Mask of a parallel-stripe geometry of 2-μm wide slits and 6-μm wide strips at a pitch of 8 μm, as illustrated on the left in Fig. 1.
*Pattern B-* Mask perforated by square openings 2 μm to a side, on the vertices of right triangles having six-fold symmetry in a pattern over which right triangles 4 μm to a side are spread, as illustrated on the right in Fig. 1.

Type 1: GaAs substrates on which an ELO mask of Pattern A configuration was formed
*Substrates 1 through 7:* Type 1; Group I inclinations 0.1°, 0.3°, 1°, 5°, 10°, 20° and 25° towards a $<1\bar{1}0>$ direction.
*Substrates 8 through 14:* Type 1; Group II inclinations 0.1°, 0.3°, 1°, 5°, 10°, 20° and 25° towards a $<11\bar{2}>$ direction.
Type 2: GaAs substrates on which an ELO mask of Pattern B configuration was formed
*Substrates 15 through 21:* Type 2; Group I inclinations 0.1°, 0.3°, 1°, 5°, 10°, 20° and 25° towards a $<1\bar{1}0>$ direction.
*Substrates 22 through 28:* Type 2; Group II inclinations 0.1°, 0.3°, 1°, 5°, 10°, 20° and 25° towards a $<11\bar{2}>$ direction.
Type 3: Substrates having neither mask, and in which growth was by a non-ELO technique
*Substrates 29 through 35:* Type 3; Group I inclinations 0.1°, 0.3°, 1°, 5°, 10°, 20° and 25° towards a $<1\bar{1}0>$ direction.
*Substrates 36 through 42:* Type 3; Group II inclinations 0.1°, 0.3°, 1°, 5°, 10°, 20° and 25° towards a $<11\bar{2}>$ direction.

Table I:

| Characterization of the 42 Different Substrates/Samples of Embodiment 1. | | | | | | | | |
|---|---|---|---|---|---|---|---|---|
| Misorientation (°) | | 0.1 | 0.3 | 1 | 5 | 10 | 20 | 25 |
| Type 1 Pattern A | I <$1\bar{1}0$> | 1 | 2 | 3 | 4 | 5 | 6 | 7 |
| | II <$11\bar{2}$> | 8 | 9 | 10 | 11 | 12 | 13 | 14 |
| Type 2 Pattern B | I <$1\bar{1}0$> | 15 | 16 | 17 | 18 | 19 | 20 | 21 |
| | II <$11\bar{2}$> | 22 | 23 | 24 | 25 | 26 | 27 | 28 |
| Type 3 Non-ELO | I <$1\bar{1}0$> | 29 | 30 | 31 | 32 | 33 | 34 | 35 |
| | II <$11\bar{2}$> | 36 | 37 | 38 | 39 | 40 | 41 | 42 |

Onto these misoriented GaAs substrates—Substrates 1 through 42—a GaN crystal layer was grown by HVPE. The HVPE system is sketched in Fig. 2. A Ga boat 3 holding metallic Ga was provided in the upper end of a reactor tube (furnace) 2, and each GaAs substrate 5 was retained by means of a susceptor 4 in the lower end. With a heater 6 surrounding the reaction tube 2, the entire reaction tube 2 was heated to maintain the Ga boat 3 and the susceptor 4 at a desired temperature. Through a first gas-supply port in the upper end, an $H_2$ + HCl gas was streamed in onto the Ga boat to create GaCl gas, and through a second gas-supply port in the upper end, an $H_2$ + $NH_3$ gas was streamed onto the GaAs substrate 5 to synthesize, and grow onto the GaAs substrates, GaN from the GaCl and $NH_3$.

In growing GaN crystal onto the GaAs substrates, at first a thin buffer layer was grown at low temperature, and then a thick epitaxial GaN film was grown at high temperature onto the buffer layer. The buffer layer was given a thickness of 20 nm to 80 nm. In the instances in which a mask is applied, it may be layered onto the substrate, or it may be layered onto the buffer layer. Alternatively, after an epitaxial layer on the order of 0.4 μm to 10 μm has been built up onto the buffer layer, the mask layer may be put onto the epilayer. In that case, the mask will be formed after the buffer layer and the epitaxial layer together are laminated 0.5 μm to 10 μm. The parameters for creating the buffer layer and epilayer were as follows.

Buffer Layer Formation Parameters

- Growth method:        HPVE
- $NH_3$ partial pressure:        0.1 atm (10,000 Pa)
- HCl partial pressure:        $1 \times 10^{-3}$ atm (100 Pa)
- Growth temperature:        500°C
- Growth time:        60 min
- Growth film thickness:        60 nm

Epilayer Thick-film Formation Parameters

- Growth method:        HPVE
- $NH_3$ partial pressure:        0.2 atm (20,000 Pa)
- HCl partial pressure:        $3 \times 10^{-2}$ atm (3000 Pa)
- Growth temperature:        1010°C
- Growth time:        10 hr
- Growth film thickness:        1.0 mm

GaN thick films were grown as indicated on the left in Fig. 3, under the conditions listed above, with GaAs Substrates 1 through 42 as starting substrates. Afterwards the GaAs substrates were removed by etching them off. Freestanding GaN crystal substrates of 1 mm thickness were thereby obtained. The GaN crystals produced using Substrates 1-42 are termed Samples 1 through 42. The GaN crystals in Samples 1-42 were in each case monocrystalline. The GaN substrate topsides were a surface having roughness, with the (0001) plane (c-plane) being broken by facets. The backsides of Samples 1-42 were in each case planar.

What is to be stressed here is that in all of Samples 1-42, the GaN crystal was grown so that the [111] orientation of the miscut GaAs substrates as bases, and the [0001] orientation of the grown GaN thick films would be parallel. The GaN [0001] orientation was inclined by an angle equal to the misorientation angle $\alpha$ of the GaAs substrate with respect to a normal projecting from the GaN substrate topside. Letting the angle that the GaN substrate [0001] orientation forms with respect to the normal projecting form its topside be the misorientation angle $\beta$ of the GaN, then the outcome of this experiment was that in all of Samples 1-42, $\beta = \alpha$.

Moreover, not only is it the case that GaN [0001] (its c-axis) was parallel to [111] of the GaAs starting substrates, strict correlations in orientation around their axes were maintained. This is a significant realization.

In the samples in which the [111] direction of the GaAs starting substrates was inclined towards a GaAs <1$\bar{1}$0> direction—that is, in which GaN was grown onto the substrates (numbers 1-7, 15-21 and 29-35) having the Group I misorientations—[0001] (the c-axis) of the GaN monocrystal was inclined towards a <$\bar{1}\bar{1}$20> direction by exactly the same angle. While the precondition (necessary parameter) is that $\beta = \alpha$—i.e., that the aforementioned axial inclinations are identical—this result meets more than just the restriction that $\beta = \alpha$. Accordingly, the significance of this is that the GaAs <1$\bar{1}$0> directions = the GaN <$\bar{1}\bar{1}$20> directions. In other words, the directions about the axes also turn out to be determined. Here, expressions using the equal sign (=) with regard to directions mean that the directions are parallel, it being that since lengths are not defined for direction vectors, parallelism is emphasized and indicated by the equal sign.

In the samples in which the [111] direction of the GaAs starting substrates was inclined towards a GaAs <11$\bar{2}$> direction—that is, in which GaN was grown onto the substrates (numbers 8-14, 22-28 and 36-42) having the Group II misorientations—[0001] (the c-axis) of the GaN monocrystal was inclined towards a <1$\bar{1}$00> direction by exactly the same angle. This means that coordinate crystal growth occurs and is such that the GaAs <11$\bar{2}$> directions = the GaN <1$\bar{1}$00> directions. Given the precondition (necessary parameter) that $\beta = \alpha$—i.e., that the axial inclinations noted earlier are identical—and that, as just noted, the GaAs <11$\bar{2}$> directions = the GaN <1$\bar{1}$00> directions, it naturally follows that such growth would occur.

Thus, this means that when GaN is grown onto miscut GaAs, both the axial direction and the orientations about the axis are decided by the orientation of the GaAs. Expressed simply, that off-axis relationships

GaAs [111] = GaN [0001],
GaAs <1$\bar{1}$0> = GaN <$\bar{1}\bar{1}$20>, and
GaAs <11$\bar{2}$> = GaN <1$\bar{1}$00>

turned out to be the case was understood from the present inventors' experiment.

These crystal plane and direction correlations were found by measuring the misorientation angle, and the off-axis direction, of the GaN crystal (0001) plane by X-ray diffraction. The fact that all of Substrates/Samples 1-42 had correspondences such as listed above means they will turn out like that with really reliable reproducibility

The radius of curvature of warpage in the Sample 1-42 GaN crystal substrates was 5 m or greater, the carrier concentration was n = 1 $\times$ 10$^{18}$ cm$^{-3}$, and the electron mobility was 100-200 cm$^2$/Vs. Such electrical characteristics are almost the same as those of freestanding GaN substrates produced by vapor-phase growth onto conventional GaAs (111) exact substrates, and compare favorably with them.

The frontsides of the Sample 1-42 freestanding GaN crystals were lapped to eliminate roughness and make the frontsides smooth, in an operation in which the flat area of the crystal backsides was a reference plane. Following this with a polishing operation allowed polishing-finished GaN substrates with a misorientation to be created.

These 42 kinds of polished wafers were examined, using an X-ray diffractometer, as to incline in the [0001] direction. The magnitude and orientation of the substrate inclination was almost the same as that of a freestanding GaN film examined by X-ray diffraction when having been rendered a short while previously.

Specifically, the Group I planarized GaN Samples 1-7, 15-21 and 29-35 were misoriented GaN crystal substrates inclined 0.1°, 0.3°, 1°, 5°, 10°, 20° and 25° towards a <$\bar{1}\bar{1}$ 20> direction, and the Group II planarized GaN Samples 8-14, 22-28 and 36-42 were misoriented GaN crystal substrates inclined 0.1°, 0.3°, 1°, 5°, 10°, 20° and 25° towards a <1$\bar{1}$00> direction. Furthermore, the crystalline properties were uniform in-plane.

An explanation will be made by specific example.

Sample 18: GaN substrate for which pattern B (repeating triangles) mask was made on a <1$\bar{1}$0> directed 5° inclined GaAs (111) A face, and GaN was grown onto the masked *A* face

On assaying this GaN Sample 18, the GaN [0001] direction was inclined 4°25 min in a < $\bar{1}$ $\bar{1}$ 20> direction, and 0°07 min in a <1 $\bar{1}$ 00> direction. According to the explanation a short while ago, the inclinations in Sample 18 ought to be 5° in the <$\bar{1}\bar{1}$ 20> direction, and 0° in the <1$\bar{1}$00> direction, but are slightly off. These are discrepancies occurring due to there being warpage in the GaN crystal thick film, and to problems in measuring. These differences are very slight; if anything, the fact that GaN misorientation can be precisely determined by misoriented GaAs as the initial base substrate should be cause for wonder.

With regard to the range of misorientation angles, with GaAs substrates in which the [111] direction was inclined 0.1°, 0.3°, 1°, 5°, 10°, 20° and 25° from the normal in the <1$\bar{1}$0> direction (Group I) and in the <11$\bar{2}$> direction (Group II), respectively, as starting substrates, GaN samples were produced by the manufacturing methods of the above-noted three types (Pattern A mask, Pattern B mask, neither mask). That growth in which the inclination direction was as far as a 25° misorientation angle was possible in both the Group I and Group II cases was verified. Accordingly, the fact that GaN crystal having misorientation of anywhere from 0 to 25° is manufacturable was confirmed.

If it were wondered, wouldn't going over 25° mean that misoriented GaN crystal could not be manufactured, the answer would be that's not so. With (111) GaAs, substrates off-axis beyond 25° have not been available, and therefore the present inventors still have not done any GaN growth experiments on GaAs substrates that exceed 25°. Thus, whether the present invention is also possible for misorientations that surpass 25° is not known; it may be possible, but then again it may not be.

Embodiment 2

*Method of manufacturing off-axis GaN substrates by growing GaN crystal onto a misoriented GaAs substrate on which GaNis grown thin, and a patterned ELO mask is provided or is not provided*

In Embodiment 1, an ELO mask was provided (or not provided) directly onto a miscut GaAs starting substrate, and GaN was epi-grown onto the masked/maskless substrate. In Embodiment 2 what was done was to put a GaN epilayer thinly onto a miscut GaAs substrate, provide (or not provide) an ELO mask on the epilayered substrate, and epi-grow GaN onto the thus prepared substrate. That is, this makes it so that the growth of GaN is in two stages, with ELO growth being done intermediately. Misoriented GaN crystal produced in this way was lapped and polished to yield smooth flat wafers, and the misorientation and crystal properties of the wafers were examined.

Likewise as in Embodiment 1, miscut GaAs substrates with the Group I misorientations—in which the GaAs [111] direction was inclined 0.1°, 0.3°, 1°, 5°, 10°, 20° and 25° towards a <1$\bar{1}$0> direction—were prepared, and miscut GaAs substrates with the Group II misorientations—in which the GaAs [111] direction was inclined 0.1°, 0.3°, 1°, 5°, 10°, 20° and 25° towards a <11$\bar{2}$> direction—were prepared.

Under the following conditions, in the same reactor as in Embodiment 1, a GaN buffer layer and epilayer were deposited onto GaAs (111) starting substrates as just characterized, to manufacture GaN crystal sheets of approximately 10 μm film thickness. The sheets thus being 10 μm thin was in order to secure planarity in the epilayer surface.

Buffer Layer Formation Parameters

- Growth method:       HPVE
- $NH_3$ partial pressure:       0.1 atm (10,000 Pa)
- HCl partial pressure:       $1 \times 10^{-3}$ atm (100 Pa)
- Growth temperature:       500°C
- Growth time:       60 min
- Growth film thickness:       60 nm

Epilayer Formation Parameters

- Growth method:       HPVE
- $NH_3$ partial pressure:       0.2 atm (20,000 Pa)
- HCl partial pressure:       $2 \times 10^{-3}$ atm (200 Pa)
- Growth temperature:       1010°C
- Growth time:       30 min
- Growth film thickness:       10 μm

Onto some of the off-axis GaN/GaAs crystal sheets, ELO masks (Patterns A and B) like those of Embodiment 1 were formed, while on others, no masks were formed.

*Pattern A*- Mask of a parallel-stripe geometry of 2-μm wide slits and 6-μm wide strips at a pitch of 8 μm, as illustrated on the left in Fig. 1.

*Pattern B*- Mask perforated, on the vertices of right triangles having six-fold symmetry in a pattern over which 4 μm right triangles are spread, by square openings 2 μm to a side, as illustrated on the right in Fig. 1.

In addition to being characterized according to the aforementioned Group I and Group II, the substrates were grouped as:

Type 1 - Substrates in which an ELO mask of Pattern A was formed onto a GaN film;

Type 2 - Substrates in which an ELO mask of Pattern B was formed onto a GaN film; and

Type 3 - Substrates without an ELO mask.

According to these categories, 42 different mask/GaN/GaAs combinations are possible. Similarly to what was done in Embodiment 1, Substrates 43 through 84 in the combinations in Table II were defined.

Table II:

| Characterization of the 42 Different Substrates/Samples of Embodiment 2. | | | | | | | | |
|---|---|---|---|---|---|---|---|---|
| Misorientation (°) | | 0.1 | 0.3 | 1 | 5 | 10 | 20 | 25 |
| Type 1 Pattern A | I <1$\bar{1}$0> | 43 | 44 | 45 | 46 | 47 | 48 | 49 |
| | II <11$\bar{2}$> | 50 | 51 | 52 | 53 | 54 | 55 | 56 |
| Type 2 Pattern B | I <1$\bar{1}$0> | 57 | 58 | 59 | 60 | 61 | 62 | 63 |
| | II <11$\bar{2}$> | 64 | 65 | 66 | 67 | 68 | 69 | 70 |
| Type 3 Maskless | I <1$\bar{1}$0> | 71 | 72 | 73 | 74 | 75 | 76 | 77 |
| | II <11$\bar{2}$> | 78 | 79 | 80 | 81 | 82 | 83 | 84 |

Onto these 42 different mask/GaN/GaAs composite substrates, a thick GaN epi-growth film was formed at high temperature.

Epilayer Formation Parameters

- Growth method: HPVE
- $NH_3$ partial pressure: 0.2 atm (20,000 Pa)
- HCl partial pressure: $3 \times 10^{-2}$ atm (3000 Pa)
- Growth temperature: 1010°C
- Growth time: 10 hr
- Growth film thickness: 1.0 mm

After thus epitaxially growing thick GaN, the GaAs substrates and the masks were etched off the 42 different (Sample 43-84) mask/GaN/GaAs composite substrates, yielding freestanding GaN crystal substrates of 1.0 mm thickness.

The GaN substrate backsides were planar. The GaN substrate topsides were a surface having roughness, with the (0001) plane being broken by facets.

In Embodiment 2 as well, the misorientation angle β of the GaN of Samples 43-84 was equal to the misorientation angle α of the GaAs substrates *(β = α)*. Moreover, the GaAs <1$\bar{1}$0> directions and the GaN <$\bar{1}\bar{1}$20> directions matched, while the GaAs <11$\bar{2}$> directions and the GaN <1$\bar{1}$00> directions coincided.

The frontsides of the GaN thick-film crystals were lapped to eliminate roughness and make the frontsides smooth, in an operation in which the flat area of the crystal backsides was a reference plane. Following this with a polishing operation on the GaN thick-film crystals produced polished off-axis GaN substrates having smooth, flat frontsides (cf. Fig. 3).

The smooth, flat GaN substrates were examined, using an X-ray diffractometer, as to incline in the [0001] direction. It was found that, as was the case in Embodiment 1, the GaN frontsides were inclined towards an intended direction at the same misorientation angle as the GaAs misorientation angle (β = α). And the crystalline properties of Samples 43-84 were uniform in-plane.

Embodiment 3

*Method of manufacturing a plurality of GaN wafers by growing GaN thick onto a misoriented GaAs substrate, and cutting through the GaN crystal*

A plurality of GaN wafers was prepared with, as starting substrates, GaAs substrates inclined in either of two directions and of seven differing misorientations, onto which a Pattern-A ELO mask, a Pattern-B ELO mask, or no mask was formed, by initially growing a thin GaN buffer layer, and afterwards a thick (10 mm) GaN epilayer, and cutting through the GaN parallel to the growth plane. The characteristics of the GaN wafers thus prepared were examined.
GaAs (111) A face
Inclination angles: 0.1°, 0.3°, 1°, 5°, 10°, 20° and 25°.

*Group I-* GaAs [111] direction inclined towards a $<1\bar{1}0>$ direction.
*Group II-* GaAs [111] direction inclined towards a $<11\bar{2}>$ direction.

Type 1 - Substrates in which an ELO mask of Pattern A was formed onto a GaN film;
Type 2 - Substrates in which an ELO mask of Pattern B was formed onto a GaN film; and
Type 3 - Substrates without an ELO mask.

*Pattern A-* Mask of a parallel-stripe geometry of 2-μm wide slits and 6-μm wide strips at a pitch of 8 μm, as illustrated on the left in Fig. 1.
*Pattern B-* Mask perforated by square openings 2 μm to a side, on the vertices of right triangles having six-fold symmetry in a pattern over which right triangles 4 μm to a side are spread, as illustrated on the right in Fig. 1.

Table III:

| Characterization of the 42 Different Substrates/Samples of Embodiment 3. | | | | | | | | |
|---|---|---|---|---|---|---|---|---|
| Misorientation (°) | | 0.1 | 0.3 | 1 | 5 | 10 | 20 | 25 |
| Type 1 Pattern A | I $<1\bar{1}0>$ | 85 | 86 | 87 | 88 | 89 | 90 | 91 |
| | II $<11\bar{2}>$ | 92 | 93 | 94 | 95 | 96 | 97 | 98 |
| Type 2 Pattern B | I $<1\bar{1}0>$ | 99 | 100 | 101 | 102 | 103 | 104 | 105 |
| | II $<11\bar{2}>$ | 106 | 107 | 108 | 109 | 110 | 111 | 112 |
| Type 3 Maskless | I $<1\bar{1}0>$ | 113 | 114 | 115 | 116 | 117 | 118 | 119 |
| | II $<11\bar{2}>$ | 120 | 121 | 122 | 123 | 124 | 125 | 126 |

The substrates are classified into 42 types, as in the above table. These are rendered Substrates 85 through 126. The GaN crystal produced using these substrates are rendered Samples 85 through 126. Initially a thin buffer layer was formed at low temperature, and subsequently a thick epilayer was formed at high temperature.

Buffer Layer Formation Parameters

- Growth method:        HPVE
- NH$_3$ partial pressure:       0.1 atm (10,000 Pa)
- HCl partial pressure:      $1 \times 10^{-3}$ atm (100 Pa)
- Growth temperature:       500°C
- Growth time:        60 min
- Growth film thickness:       60 nm

Epilayer Formation Parameters

- Growth method:          HPVE
- NH$_3$ partial pressure:        0.2 atm (20,000 Pa)
- HCl partial pressure:        3 × 10$^{-3}$ atm (300 Pa)
- Growth temperature:        1010°C
- Growth time:        100 hr
- Growth film thickness:        10 mm

In this way, composite GaN/GaAs substrates having a height of 10 mm or more were obtained. In all the samples, the GaN misorientation angle β and the GaAs misorientation angle α were equal (β = α). The inclinations angles also were the same, with the GaAs <1$\bar{1}$0> directions being equal to the GaN <$\overline{11}$20> directions, and the GaAs <11$\bar{2}$> directions being equal to the GaN <1$\bar{1}$00> directions.

The GaAs and the masks were removed by etching them off, which yielded freestanding GaN crystals of 10 mm thickness. The backsides of the GaN crystals were planar. The GaN crystal topsides were a surface having roughness, with the (0001) plane being broken by facets.

The frontsides of these GaN boules were lapped to eliminate roughness and make the frontsides smooth, in an operation in which the flat area of the boule backsides was a reference plane. This resulted in columnar GaN boules. With the planar face of the backside made a reference plane, the boules were sliced with a wire saw perpendicularly to the normal to the backside. From the boules it was possible to cut ten GaN wafers of 400 μm thickness.

These sliced wafers were polished, enabling GaN wafers with a misorientation to be manufactured. The wafers were examined with an X-ray diffractometer as to incline in the [0001] direction. The samples in all cases were ascertained to be misoriented wafers that were off-axis by an intended angle in an intended orientation. Furthermore, the crystalline properties were uniform in-plane.

Owing to this technique in which GaN is thus thick-film grown onto a miscut GaAs substrate and is cut along parallel planes, a greater number of miscut GaN wafers can be obtained. In the present embodiment, for example, from a 10-mm thick boule (7 mm actually usable range), ten 2-inch diameter GaN wafers that were 5° off-axis and 400 μm in thickness could be cut.

On the other hand, if it is from a 2-inch diameter, 10-mm thick freestanding GaN crystal that is not misoriented that 400 μm thick, 5° off-axis wafers are to be cut, the slicing plane would not be parallel to the crystal backside, but would be inclined 5°. Consequently, only five 5° off-axis wafers could be obrtained. In contrast, the present invention, in which misoriented boules are produced from the start, is extremely useful and is effective in curtailing the cost of off-axis GaN wafers.

Embodiment 4

*Method of manufacturing off-axis GaN substrates by growing GaN onto an off-axis GaN substrate*

Discussed in the foregoing has been the growing of GaN onto miscut GaAs starting substrates. In Embodiment 4, misoriented GaN is utilized as a starting substrate. Inasmuch as the misoriented GaN substrates manufactured in Embodiment were available, they were utilized as seed crystal. That is, until this point the starting substrates have been miscut GaAs, but herein off-axis GaN was made the starting substrate. Accordingly, in this case the growth is not heteroepitaxial, but homoepitaxial.

The GaN substrates were characterized as follows; accordingly there were 14 types. Those having the seven Group I misorientations were designated Substrates 127 through 133; those having the seven Group II misorientations were designated Substrates 134 through 140.

*Group I* - Misorientations in which the GaN [0001] (*c*-axis) direction inclined towards a <$\overline{11}$20> direction.
*Group II*- Misorientations in which the GaN [0001] (c-axis) direction inclined towards a <1$\bar{1}$00> direction.
Inclination angles: 0.1°, 0.3°, 1°, 5°, 10°, 20° and 25°.

Table IV:

| Characterization of the 14 Different Substrates/Samples of Embodiment 4. | | | | | | | | |
|---|---|---|---|---|---|---|---|---|
| Misorientation (°) | | 0.1 | 0.3 | 1 | 5 | 10 | 20 | 25 |
| (Maskless) | I <$\overline{11}$20> | 127 | 128 | 129 | 130 | 131 | 132 | 133 |
| | II <1$\overline{1}$00> | 134 | 135 | 136 | 137 | 138 | 139 | 140 |

Since the GaN was seed crystal, ELO was not employed. The GaN substrates went through a cleaning process.

Cleaning Parameters

- Cleaning temperature: 1000°C
- $NH_3$ partial pressure: 0.4 atm (40,000 Pa)
- Cleaning time: 10 min

Under these conditions, a cleaning operation was carried out on the topside of the substrates. Thick-film growth of GaN was done at high temperature directly, without a low-temperature buffer layer being sandwiched in.

Epi-growth Parameters

- Growth method: HPVE
- $NH_3$ partial pressure: 0.2 atm (20,000 Pa)
- HCl partial pressure: $3 \times 10^{-3}$ atm (300 Pa)
- Growth temperature: 1010°C
- Growth time: 100 hr
- Growth film thickness: 10 mm

Epitaxial growth under these conditions enabled freestanding GaN boules of 10 mm thickness to be produced.
The GaN boules grew homoepitaxially, taking on unaltered the crystal orientation of the GaN base as a starting substrate. The misorientation angle β of the growth portion of GaN and the misorientation angle α, of the base GaN were therefore equal. Moreover, from GaN starting substrates of the Group I misorientations (Substrates 127-133), in which the c-axis was inclined towards a <$\overline{11}$20> direction, off-axis GaN in which likewise the c-axis was inclined towards a < $\overline{1}$ $\overline{1}$ 20> direction was produced. The same was true of the substrates of the Group II misorientations (Substrates 134-140).
The backsides of the GaN boules were planar, but roughness appeared in the topsides, which turned out as mixed surfaces of (0001) faces and facets. The frontsides were lapped in an operation to eliminate roughness. With the planar face of the backside as a reference plane, the boules were sliced with a wire saw parallel to the backside. From the boules it was possible to cut ten GaN wafers 400 μm in thickness. These wafers underwent a polishing operation, enabling GaN polished substrates with a misorientation to be obtained.
The wafers thus obtained were examined for incline in the [0001] direction by means of an X-ray diffractometer. The GaN wafers were found to have the same crystal orientation and off-axis angle as the seed-crystal GaN.

Embodiment 5

*GaN film epi-growth, fabrication ofLEDs onto off-axis GaN substrates*

A GaN epilayer was grown by MOCVD onto a GaN substrate having a misorientation of 1° as manufactured in Embodiment 1. In epitaxially growing onto a c-plane exact substrate not having a misorientation, roughness in the surface has resulted, but in a GaN epilayer grown onto an off-axis GaN substrate of the present invention the morphology improves, with the layer turning out flat, and this brings out a virtue of misoriented substrates.
A blue LED in which InGaN was the light-emitting layer was fabricated onto the GaN epilayer grown on the 1° misoriented GaN. The brightness of the LED produced atop the off-axis substrate was greater than that of an LED produced atop an on-axis substrate. This is because the morphology of the epilayer is better, and that superiority originates in the misorientation. Misoriented GaN substrates enable the manufacture of LEDs whose brightness is greater than that of devices on c-plane exact substrates.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

**Claims**

1. A method of manufacturing a GaN single-crystal substrate utilizing a misoriented (111) GaAs baseplate as a starting substrate, the method comprising:

   a growth step of depositing a GaN single-crystal layer onto the misoriented (111) GaAs starting substrate; and
   a removal step, subsequent to said growth step, of removing the starting substrate to produce a misoriented freestanding GaN substrate.

2. A method of manufacturing a GaN single-crystal substrate utilizing a misoriented (111) GaAs baseplate as a starting substrate, the method comprising:

   a mask-formation step of forming onto the misoriented (111) GaAs starting substrate a mask having a plurality of apertures;
   a growth step of depositing through the mask a GaN single-crystal layer; and
   a removal step, subsequent to said growth step, of removing the starting substrate to produce a misoriented freestanding GaN substrate.

3. A method of manufacturing a GaN single-crystal substrate utilizing a misoriented (111) GaAs baseplate as a starting substrate, the method comprising:

   an epilayer formation step of forming at a thickness of 0.5 $\mu$m to 10 $\mu$m a GaN epitaxial layer onto the misoriented (111) GaAs starting substrate;
   a mask-formation step of forming onto the epilayer a mask layer having a plurality of apertures;
   a growth step of depositing through the mask a GaN single-crystal layer; and
   a removal step, subsequent to said growth step, of removing the starting substrate to produce a misoriented freestanding GaN substrate.

4. A method of manufacturing GaN single-crystal substrates utilizing a misoriented (111) GaAs baseplate as a starting substrate, the method comprising:

   a mask-formation step of forming onto the misoriented (111) GaAs starting substrate a mask layer having a plurality of apertures;
   a growth step of depositing through the mask a GaN single-crystal layer having thickness sufficient to yield a plurality of wafers; and
   a slicing step, subsequent to said growth step, of slicing the GaN single-crystal layer along its thickness to produce a plurality of misoriented freestanding GaN substrates.

5. A method of manufacturing GaN single-crystal substrates utilizing a misoriented freestanding GaN baseplate as a starting substrate, the method comprising:

   a growth step of depositing onto the misoriented GaN starting substrate a GaN single-crystal layer having thickness sufficient to yield a plurality of wafers; and
   a slicing step, subsequent to said growth step, of slicing the GaN single-crystal layer along its thickness to produce a plurality of misoriented freestanding GaN substrates.

6. A GaN single-crystal substrate manufacturing method as set forth in any of claims 1-4, wherein the off-axis angle of the misoriented GaAs starting substrate is 0.3° to 20°.

7. A GaN single-crystal substrate manufacturing method as set forth in any of claims 1-4, wherein the off-axis angle of the misoriented GaAs starting substrate is 0.1° to 25°.

8. A GaN single-crystal substrate manufacturing method as set forth in any of claims 1-4, wherein the misoriented GaAs starting substrate is a (111)-plane baseplate having a misorientation in which, in terms of a vector normal to the baseplate topside, the [111]-directed plane is inclined towards a <1$\bar{1}$0> direction.

9. A GaN single-crystal substrate manufacturing method as set forth in any of claims 1-4, wherein the misoriented GaAs starting substrate is a (111)-plane baseplate having a misorientation in which the [111]-directed plane is inclined towards a <11$\bar{2}$> direction.

10. A GaN single-crystal substrate manufactured by utilizing a misoriented (111) GaAs baseplate as a starting substrate, depositing a GaN single-crystal layer onto said misoriented (111) GaAs starting substrate, and then removing said starting substrate to produce a misoriented freestanding GaN substrate.

11. A GaN single-crystal substrate manufactured by utilizing a misoriented (111) GaAs baseplate as a starting substrate, forming onto said misoriented (111) GaAs starting substrate a mask having a plurality of apertures, depositing through said mask a GaN single-crystal layer, and then removing said starting substrate to produce a misoriented freestanding GaN substrate.

12. A GaN single-crystal substrate manufactured by utilizing a misoriented (111) GaAs baseplate as a starting substrate, forming at a thickness of 0.5 μm to 10 μm a GaN epitaxial layer onto said misoriented (111) GaAs starting substrate, forming onto said epilayer a mask layer having a plurality of apertures, depositing through said mask a GaN single-crystal layer, and then removing said starting substrate to produce a misoriented freestanding GaN substrate.

13. GaN single-crystal substrates manufactured by utilizing a misoriented (111) GaAs baseplate as a starting substrate, forming onto said misoriented (111) GaAs starting substrate a mask layer having a plurality of apertures, depositing through said mask a GaN single-crystal layer having thickness sufficient to yield a plurality of wafers, and then slicing said GaN single-crystal layer along its thickness to produce a plurality of misoriented freestanding GaN substrates.

14. GaN single-crystal substrates manufactured by utilizing a misoriented freestanding GaN baseplate as a starting substrate, depositing onto said misoriented GaN starting substrate a GaN single-crystal layer having thickness sufficient to yield a plurality of wafers, and then slicing said GaN single-crystal layer along its thickness to produce a plurality of misoriented freestanding GaN substrates.

15. A misoriented GaN single-crystal freestanding substrate whose off-axis angle is 0.3° to 20°.

16. A misoriented GaN single-crystal freestanding substrate whose off-axis angle is 0.1° to 25°.

## FIG. 1

Pattern A

Pattern B

4 μm

Stripe pitch: 8 μm    Slit: 2 μm

2 μm

## FIG. 2

H2+HCl    H2+NH3

HVPE

2

3

6
Heater

GaCl

NH3

GaN

4

Wafer

5

FIG. 3

**Manufacturing method of Embodiments 1 & 2**

Mask (pattern) formation

Off-axis GaAs substrate

↓ Low-temp. buffer layer

Off-axis GaAs substrate

↓

Epitaxial layer
GaN (thick film, boule)

Off-axis GaAs substrate ⇨ Etching removal

↓ Lapping, slicing, polishing

Off-axis GaN substrate

**Manufacturing method of Embodiment 4**

Off-axis GaN substrate

↓

Epitaxial layer
GaN (thick film, boule)

Off-axis GaN substrate

↓ Lapping, slicing, polishing

Off-axis GaN substrate

**Manufacturing method of Embodiment 3**

Low-temp. buffer layer + Epi-GaN (10 $\mu$m)

Off-axis GaAs substrate

↓ Mask (pattern) formation

Off-axis GaAs substrate

↓

Epitaxial layer
GaN (thick film, boule)

⇦ Off-axis GaAs substrate

Etching removal ↓ Lapping, slicing, polishing

Off-axis GaN substrate

EP 1 577 933 A2

# FIG. 4

Present invention method of manufacturing vicinal substrates

Slicing with wire saw

GaAs (111)
Vicinal substrate

FIG. 5

N

Ga

FIG. 6